(19) Europäisches Patentamt
European Patent Office
Office européen des brevets

(11) Publication number: **0 430 430 B1**

(12) **EUROPEAN PATENT SPECIFICATION**

(45) Date of publication of patent specification: **21.09.94**

(51) Int. Cl.$^5$: **C08G 73/10**

(21) Application number: **90311673.9**

(22) Date of filing: **24.10.90**

(54) **Polyimide.**

(30) Priority: **17.11.89 JP 297518/89**

(43) Date of publication of application:
**05.06.91 Bulletin 91/23**

(45) Publication of the grant of the patent:
**21.09.94 Bulletin 94/38**

(84) Designated Contracting States:
**BE CH DE FR GB IT LI NL**

(56) References cited:
**GB-A- 2 199 586**

(73) Proprietor: **MITSUI TOATSU CHEMICALS, Inc.**
**2-5 Kasumigaseki 3-chome**
**Chiyoda-Ku Tokyo 100 (JP)**

(72) Inventor: **Tamai, Shoji**
**Iijima-Cho 2882,**
**Sakae-Ku**
**Yokohama-shi, Kanagawa-ken 244 (JP)**
Inventor: **Ohta, Masahiro**
**Shozan-Machi 97**
**Ohmuta-shi, Fukuoka-ken 836 (JP)**
Inventor: **Yamaguchi, Akihiro**
**Zaimokuza 1-13-24**
**Kamakura-shi, Kanagawa-ken 248 (JP)**

(74) Representative: **Stuart, Ian Alexander et al**
**MEWBURN ELLIS**
**York House**
**23 Kingsway**
**London WC2B 6HP (GB)**

**EP 0 430 430 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a novel polyimide, and particularly relates to a polyimide having a high heat-resistance and good processability.

A polyimide obtained by reacting tetracarboxylic acid dianhydride and diamine compound has conventionally been used in various fields due to excellent properties and good thermal-resistance, and is expected to be applied to various fields where high-temperature stability is required.

Many kinds of polymide which have conventionally been developed exhibit excellent properties. However, polyimide having excellent thermal-resistance shows poor processability while the resin developed for improving processability is poor in resistance to heat and solvent. Thus characteristics and drawbacks have been found in combination.

For example, polyimide consisting of a fundamental skelton represented by the formula (II):

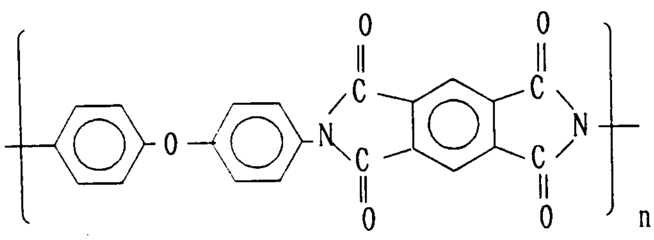

(II)

(Trade Mark; Kapton and Vespel, the products of E.I.Du Pont De Nemours & Co. Inc.) has no definite glass transition temperature and is excellent in high-temperature resistance. The polyimide, however, is difficult to process as a molding material and must be processed by specific methods such as sinter molding. The polyimide has also high water absorption which gives adverse effects on dimensional stability, insulative property and solder heat resistance of electric and electronic parts.

Polyetherimide consisting of a fundamental skeleton represented by the formula (III):

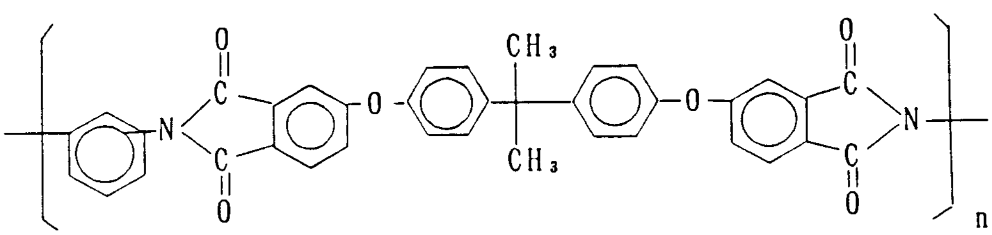

(III)

(Trade Mark; ULTEM, a product of General Electric Co.) is a resin having excellent processability. The resin, however, has a glass transition temperature of 217 °C and is soluble in halogenated hydrocarbons such as methylene chloride. Hence, the resin is unsatisfactory in view of resistance of high temperature and solvents.

In preferred embodiments the present invention may provide polyimide which has, in addition to substantially excellent heat resistance of polyimide, outstanding processability, low water absorption, good transparency, and excellent adhesion at high temperature and can be used for multipurpose applications.

As a result of carrying out an intensive investigation in order to achieve the above object, the present inventors have found a polyimide which is highly heat-resistant and also has good processability.

Accordingly, one aspect of the present invention is a polyimide having recurring structural units represented by the formula (I):

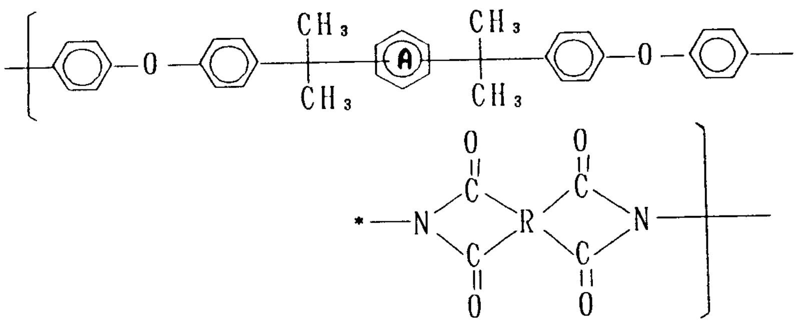

( I )

wherein R is a tetravalent radical selected from an aliphatic radical having at least two carbon atoms, alicyclic radical, monocyclic aromatic radical, fused polycyclic aromatic radical and polycyclic aromatic radical bonded through a direct bond or a bridge member; and ring A is 1,3 or 1,4-substituted.

The polyimide of the invention may be obtainable polymerizing, as a diamine component, 1,4-bis[4-(4-aminophenoxy)-α,α-dimethylbenzyl] benzene and/or 1,3-bis [4-(4-aminophenoxy)-α,α-dimethylbenzyl] benzene having the formula (IV):

(IV )

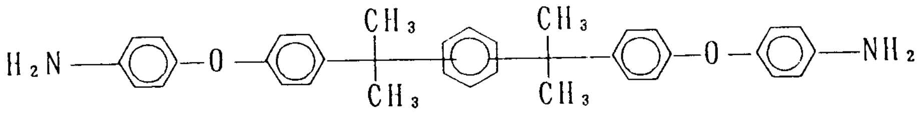

with a single compound or a mixture of tetracarboxylic acid dianhydride.

Preferred embodiments are characterized by 1,4-bis[4-(4-aminophenoxy)-α,α-dimethylbenzyl] benzene and, 1,3-bis [4-(4-aminophenoxy)-α,α-dimethylbenzyl] benzene as a diamine component and is particularly excellent in processability and heat-resistance.

A polyimide obtained by reacting an ether diamine which has a similar structure to the above diamine compound and is illustrated by the formula (V):

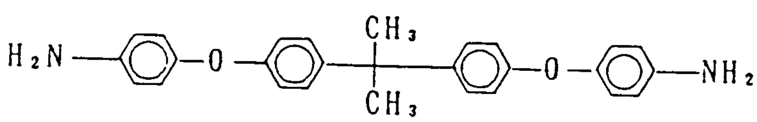

(V )

that is, 2,2-bis [4-(4-aminophenoxy)phenyl] propane, with pyromellitic dianhydride has a high glass transition temperature of 300 °C or more, low melt flowability at high temperatures, very low adhesive strength and poor processability as disclosed in Japanese Patent Laid-Open Publication SHO 61-291669(1986).

The polyimide of the invention is thermoplastic while maintaining excellent heat-resistance and thus has very good processability. These polyimides are highly heat resistant and can be melt-molded.

Further a polyimide of the invention may have low water absorption in addition to the above outstanding processability and be very useful for the base material of space and aeronautical members and electric and electronic parts, and also as a heat-resistant adhesive.

As mentioned above, the polyimide of the present invention has excellent processability and may have lower water absorption and good solvent resistance in addition to exhibiting substantially excellent heat resistance.

Consequently, the present invention can provide a novel polyimide which can be used for multi-purpose applications and is very useful in industry.

Brief Description of the Drawings

The drawings are IR absorption spectra of polyimide of the invention. Figure 1 illustrates the IR absorption spectrum of polyimide powder obtained in Example 1. Figure 2 illustrates the IR absorption spectrum of polyimide powder obtained in Example 2.

Detailed Description of the Invention

The polyimide of the present invention is a polyimide having recurring structural units represented by the formula (I)

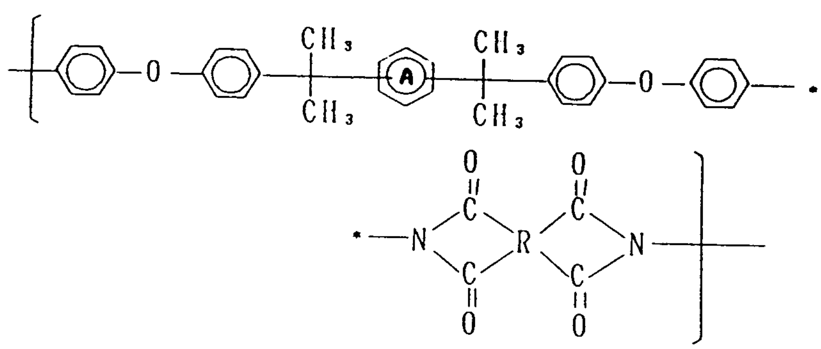

( I )

wherein R is the same as above and ring A is 1,3 or 1,4-substituted.

For example, preferred polyimides include polyimide having recurring structural units illustrated by the formula (VI):

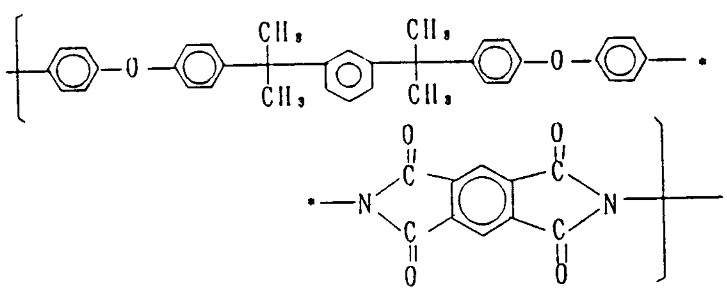

(VI )

or by the formula (VII):

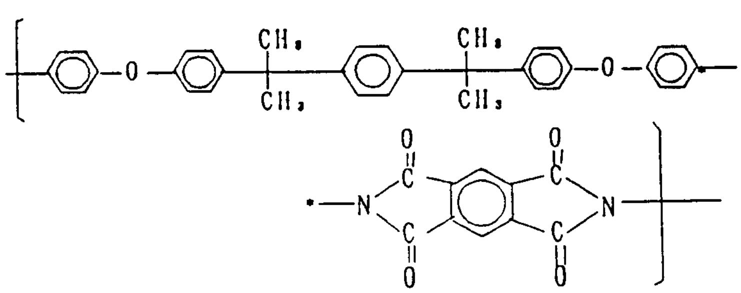

(VII )

The polyimide of the invention uses 1,4-bis [4-(4-aminophenoxy)-$\alpha$,$\alpha$-dimethylbenzyl] benzene and/or 1,3-bis [4-(4-aminophenoxy)-$\alpha$,$\alpha$-dimethylbenzyl] benzene as diamine components.

The polyimide of the invention is prepared from the above diamine compounds. However, other diamine compounds can also be used in combination with the above diamine compounds as long as the good properties of the polyimide are not impaired. Examples of other aromatic diamines which can be simultaneously used include

m-phenylenediamine, o-phenylenediamine, p-phenylenediamine,
m-aminobenzylamine, p-aminobenzylamine, bis(3-aminophenyl) ether,
(3-aminophenyl)(4-aminophenyl)ether, bis(4-aminophenyl) ether,
bis(3-aminophenyl) sulfide, (3-aminophenyl)(4-aminophenyl) sulfide,
bis(4-aminophenyl) sulfide, bis(3-aminophenyl) sulfoxide,
(3-aminophenyl)(4-aminophenyl) sulfoxide,
bis(4-aminophenyl) sulfoxide, bis(3-aminophenyl) sulfone,
(3-aminophenyl)(4-aminophenyl) sulfone,
bis(4-aminophenyl) sulfone, 3,3′-diaminobenzophenone,
3,4′-diaminobenzophenone, 4,4′-diaminobenzophenone,
3,3′-diaminodiphenylmethane, 3,4′-diaminodiphenylmethane,
4,4′-diaminodiphenylmethane, bis [4-(3-aminophenoxy)phenyl] methane,
bis [4-(4-aminophenoxy)phenyl] methane,
1,1-bis [4-(3-aminophenoxy)phenyl] ethane,
1,1-bis [4-(4-aminophenoxy)phenyl] ethane,
1,2-bis [4-(3-aminophenoxy)phenyl] ethane,
1,2-bis [4-(4-aminophenoxy)phenyl] ethane,
2,2-bis [4-(3-aminophenoxy)phenyl] propane,
2,2-bis [4-(4-aminophenoxy)phenyl] propane,
2,2-bis [4-(3-aminophenoxy)phenyl] butane,
2,2-bis [4-(4-aminophenoxy)phenyl] butane,
2,2-bis [4-(3-aminophenoxy)phenyl] 1,1,1,3,3,3-hexafluoropropane,
2,2-bis [4-(4-aminophenoxy)phenyl] 1,1,1,3,3,3-hexafluoropropane,
1,3-bis(3-aminophenoxy)benzene, 1,3-bis(4-aminophenoxy)benzene,
1,4-bis(3-aminophenoxy)benzene, 1,4-bis(4-aminophenoxy)benzene,
4,4′-bis(3-aminophenoxy)biphenyl, 4,4′-bis(4-aminophenoxy)biphenyl,
bis [4-(3-aminophenoxy)phenyl] ketone,
bis [4-(4-aminophenoxy)phenyl] ketone,
bis [4,(3-aminophenoxy)phenyl] sulfide,
bis [4,(4-aminophenoxy)phenyl] sulfide,
bis [4-(3-aminophenoxy)phenyl] sulfoxide,
bis [4-(4-aminophenoxy)phenyl] sulfoxide,
bis [4-(3-aminophenoxy)phenyl] sulfone,
bis [4-(4-aminophenoxy)phenyl] sulfone,
bis [4-(3-aminophenoxy)phenyl] ether,
bis [4-(4-aminophenoxy)phenyl] ether,
1,4-bis [4-(3-aminophenoxy)benzoyl] benzene,
1,3-bis [4-(3-aminophenoxy)benzoyl] benzene,
4,4'-bis [3-(4-aminophenoxy)benzoyl] diphenyl ether,
4,4'-bis [3-(3-aminophenoxy)benzoyl] diphenyl ether,
4,4'-bis [4-(4-amino-α,α-dimethylbenzyl)phenoxy] benzophenone,
4,4'-bis [4-(4-amino-α,α-dimethylbenzyl)phenoxy] diphenyl sulfone,
bis [4- {4-(4-aminophenoxy)phenoxy} phenyl] sulfone and
bis [4- {4-(3-aminophenoxy)phenoxy} phenyl] sulfone.

These aromatic diamines are used singly or as a mixture.

The polyimide of the invention can be prepared by the following process.

In the first step, 1,4-bis [4-(4-aminophenoxy)-α,α-dimethylbenzyl] benzene and/or 1,3-bis [4-(4-aminophenoxy)-α,α-dimethylbenzyl] benzene are polymerized with tetracarboxylic acid dianhydride in an organic solvent to obtain polyamic acid.

The tetracarboxylic acid dianhydride used in the process is represented by the formula (VIII):

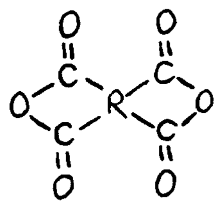

(VIII)

wherein R is a tetravalent radical selected from the group consisting of an aliphatic radical having at least two carbon atoms, alicyclic radical, monocyclic aromatic radical, fused polycyclic aromatic radical and polycyclic aromatic radical bonded through a direct bond or a bridge member.

Exemplary tetracarboxylic acid dianhydrides which can be used include ethylenetetracarboxylic dianhydride, butanetetracarboxylic dianhydride, cyclopentanetetracarboxylic dianhydride, pyromellitic dianhydride,
3,3′,4,4′-benzophenonetetracarboxylic dianhydride,
2,2′,3,3′-benzophenonetetracarboxylic dianhydride,
1,2,3,4-benzenetetracarboxylic dianhydride,
3,3′,4,4′-biphenyltetracarboxylic dianhydride,
2,2′,3,3′-biphenyltetracarboxylic dianhydride,
2,2-bis(3,4-dicarboxyphenyl)propane dianhydride,
2,2-bis(2,3-dicarboxyphenyl)propane dianhydride,
2,2-bis(3,4-dicarboxyphenyl)-1,1,1,3,3,3-hexafluoropropane dianhydride,
2,2-bis(2,3-dicarboxyphenyl)-1,1,1,3,3,3-hexafluoropropane dianhydride,
2,2-bis(3,4-dicarboxyphenyl)-1,1,1,3,3,3-hexachloropropane dianhydride,
bis(3,4-dicarboxyphenyl)ether dianhydride,
bis(2,3-dicarboxyphenyl)ether dianhydride,
bis(3,4-dicarboxyphenyl)sulfone dianhydride,
bis(2,3-dicarboxyphenyl)sulfone dianhydride,
1,1-bis(2,3-dicarboxyphenyl)ethane dianhydride,
bis(2,3-dicarboxyphenyl)methane dianhydride,
bis(3,4-dicarboxyphenyl)methane dianhydride,
2,3,6,7-naphthalenetetracarboxylic dianhydride,
1,4,5,8-naphthalenetetracarboxylic dianhydride,
1,2,5,6-naphthalenetetracarboxylic dianhydride,
3,4,9,10-perylenetetracarboxylic dianhydride,
2,3,6,7-anthracenetetracarboxylic dianhydride,
1,2,7,8-phenanthrenetetracarboxylic dianhydride,
bis [4-(3,4-dicarboxyphenoxy)phenyl] sulfide,
3,3′-(p-phenylenedioxy)diphthalic dianhydride,
4,4′-(p-phenylenedioxy)diphthalic dianhydride,
3,3′-m-phenylenedioxy)diphthalic dianhydride and
4,4′-(m-phenylenedioxy)diphthalic dianhydride.

The tetracarboxylic acid dianhydride is used singly or in combination.

Exemplary organic solvents for use in the reaction include N,N-dimethylformamide, N,N-dimethylacetamide, N,N-diethylacetamide, N,N-dimethylmethoxyacetamide, N-methyl-2-pyrrolidone, 1,3-dimethyl-2-imidazolidinone, N-methylcaprolactam, 1,2-dimethoxyethane, bis(2-methoxyethyl) ether, 1,2-bis-(2-methoxyethoxy)ethane, bis [2-(2-methoxyethoxy)ethyl) ether, tetrahydrofuran, 1,3-dioxane, 1,4-dioxane, pyridine, picoline, dimethyl sulfoxide, dimethyl sulfone, tetramethylurea, hexamethylphosphoramide, phenol, o-cresol, m-cresol, p-cresol, m-cresylic acid, p-chlorophenol and anisole.

The organic solvent can be used singly or as a mixture.

The reaction temperature is usually 250 °C or less, preferably 50 °C or less.

No particular limitation is imposed upon the reaction pressure.

The reaction can be satisfactorily carried out under atmospheric pressure.

The reaction time varies depending upon tetracarboxylic acid anhydride used, kind of solvent and reaction temperature. The reaction is usually conducted for a time sufficient to complete formation of

polyamic acid represented by the formula (IX) below. A reaction time of 4 to 24 hours is usually sufficient.

By the reaction, polyamic acid having recurring structural units represented by the formula (IX) is formed.

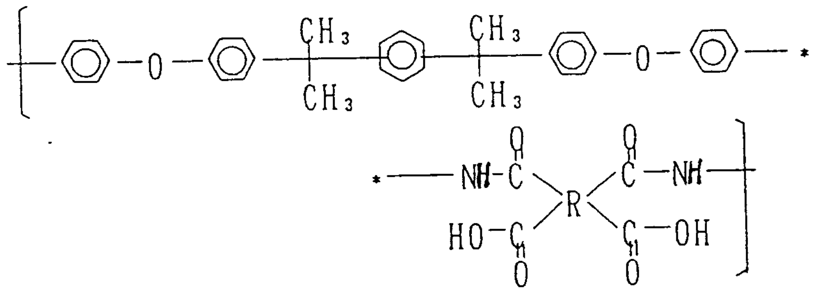

(IX)

wherein R is the same as above.

The polyamic acid is heat-dehydrated at 100 to 400 °C, or chemically imidized by using a conventional imidizing agent to give the corresponding polyimide having recurring structural units of the formula (I):

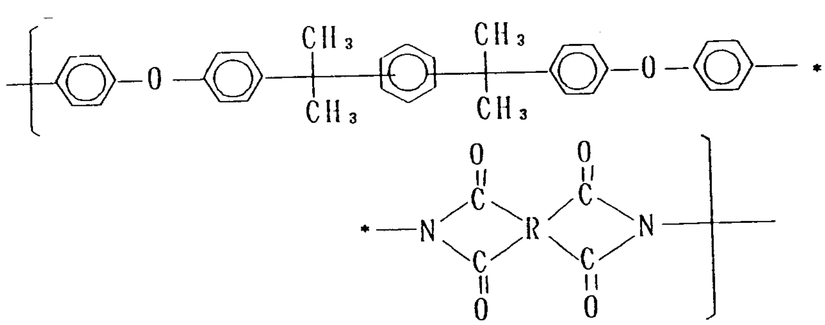

(I)

wherein R is the same as above.

Generally, polyamic acid is formed at lower temperatures and then thermally or chemically imidized.

Polyimide can also be prepared by simultaneously carrying out formation of polyamic acid and imidization by heat. That is, 1,4-bis [4-(4-aminophenoxy)-α,α-dimethylbenzyl] benzene and/or 1,3-bis [4-(4-aminophenoxy)-α,α-dimethylbenzyl] benzene are reacted with tetracarboxylic acid anhydride by heating after suspending or dissolving in the organic solvent. Thus, formation of polyamic acid and imidization by dehydration are conducted at the same time to obtain the polyimide having recurring structural units of the above formula (I).

In the practice of the above reaction, a dicarboxylic acid anhydride and/or a monoamine compound are sometimes added as a molecular weight controller or a chain terminator.

No particular limitation is placed upon the amount of dicarboxylic acid anhydride and/or the monoamine compound. The amount added is usually from 0.001 mole to 1.0 mole per mole of principal raw material monomer.

The reaction in the presence of the dicarboxylic acid anhydride and/or the monoamine compound can be carried out by any of the following methods.

(a) Tetracarboxylic acid dianhydride is reacted with 1,4-bis [4-(4-aminophenoxy)-α,α-dimethylbenzyl] benzene and/or 1,3-bis [4-(4-aminophenoxy)-α,α-dimethylbenzyl] benzene, followed by adding dicarboxylic acid anhydride and/or the monoamine compound and the reaction is further continued.

(b) 1,4-Bis [4-(4-aminophenoxy)-α,α-dimethylbenzyl] -benzene and/or 1,3-bis [4-(4-aminophenoxy)-α,α-dimethylbenzyl] -benzene are reacted with dicarboxylic acid anhydride and then tetracarboxylic dianhydride is added to continue the reaction.

(c) Tetracarboxylic acid dianhydride is previously reacted with the monoamine compound and then 1,4-bis [4-(4-aminophenoxy)-α,α-dimethylbenzyl] benzene and/or 1,3-bis [4-(4-aminophenoxy)-α,α-dimethylbenzyl] benzene are added to continue the reaction.

(d) The reaction is conducted by simultaneous mixing 1,4-bis [4-(4-aminophenoxy)-α,α-dimethylbenzyl] benzene and/or 1,3-bis [4-(4-aminophenoxy)-α,α-dimethylbenzyl] -benzene, tetracarboxylic acid dianhydride, and dicarboxylic acid anhydride and/or the monoamine compound.

Alternatively, 1,4-bis [4-(4-aminophenoxy)-α,α-dimethylbenzyl] benzene and/or 1,3-bis [4-(4-aminophenoxy)-α,α-dimethylbenzyl] benzene, tetracarboxylic acid dianhydride, and dicarboxylic acid anhydride and/or the diamine compound are suspended or dissolved in the organic solvent and heated to carry out the reaction. Thus polyimide can also be prepared by conducting the formation of polyamic acid, i.e., the precursor of polyimide, and imidization at the same time.

Exemplary dicarboxylic acid anhydrides suitable for use in the above methods includes phthalic anhydride,
2,3-benzophenonedicarboxylic anhydride,
3,4-benzophenonedicarboxylic anhydride,
2,3-dicarboxyphenylphenyl ether anhydride,
3,4-dicarboxyphenylphenyl ether anhydride,
2,3-biphenyldicarboxylic anhydride,
3,4-biphenyldicarboxylic anhydride,
2,3-dicarboxyphenylphenyl sulfone anhydride,
3,4-dicarboxyphenylphenyl sulfone anhydride,
2,3-dicarboxyphenylphenyl sulfide anhydride,
3,4-dicarboxyphenylphenyl sulfide anhydride,
1,2-naphthalenedicarboxylic anhydride,
2,3-naphthalenedicarboxylic anhydride,
1,8-naphthalenedicarboxylic anhydride,
1,2-anthracenedicarboxylic anhydride,
2,3-anthracenedicarboxylic anhydride and
1,9-anthracenedicarboxylic anhydride.

Exemplary monoamine compound which can be used in the reaction includes aniline, o-toluidine, m-toluidine, p-toluidine, 2,3-xylidine,
2,4-xylidine, 2,5-xylidine, 2,6-xylidine, 3,4-xylidine, 3,5-xylidine,
o-chloroaniline, m-chloroaniline, p-chloroaniline, o-bromoaniline,
m-bromoaniline, p-bromoaniline, o-nitroaniline, m-nitroaniline,
p-nitroaniline, o-aminophenol, m-aminophenol, p-aminophenol,
o-anisidine, m-anisidine, p-anisidine, o-phenetidine, m-phenetidine,
p-phenetidine, o-aminobenzaldehyde, m-aminobenzaldehyde,
p-aminobenzaldehyde, o-aminobenzotrifluoride, m-aminobenzotrifluoride,
p-aminobenzotrifluoride, o-aminobenzonitrile, m-aminobenzonitrile,
p-aminobenzonitrile, 2-aminobiphenyl, 3-aminobiphenyl,
4-aminobiphenyl, 2-aminophenyl phenyl ether,
3-aminophenyl phenyl ether, 4-aminophenyl phenyl ether,
2-aminobenzophenone, 3-aminobenzophenone, 4-aminobenzophenone,
2-aminophenyl phenyl sulfide, 3-aminophenyl phenyl sulfide,
4-aminophenyl phenyl sulfide, 2-aminophenyl phenyl sulfone,
3-aminophenyl phenyl sulfone, 4-aminophenyl phenyl sulfone,
α-naphthylamine, β-naphthylamine, 1-amino-2-naphthol,
2-amino-1-naphthol, 4-amino-1-naphthol, 5-amino-1-naphthol,
5-amino-2-naphthol, 7-amino-2-naphthol, 8-amino-1-naphthol,
8-amino-2-naphthol, 1-aminoanthracene, 2-aminoanthracene and
9-aminoanthracene.

That is, the polyimide having recurring structural units of the above formula (I) can be obtained by using conventionally known methods.

In the melt-molding of the polyimide of the invention, other thermoplastic resins can also be incorporated in a suitable amount depending upon the object as long as the resin gives no adverse effects on the objects of the invention.

Examples of the thermoplastic resins which can be used include, polyethylene, polypropylene, polycarbonate, polyarylate, polyamide, polysulfone, polyether sulfone, polyether ketone, polyphenylene sulfide, polyamideimide, polyetherimide and modified polyphenylene oxide.

Fillers used for a conventional resin compositions can also be added in an amount giving no adverse effects on the objects of the invention. Representative examples of the fillers include abrasion resistance improvers such as graphite, carborundum, quartz powder, molybdenum disulfide, and fluoro plastics; reinforcements such as glass fibers, carbon fibers, boron fibers, silicon carbide fibers, carbon whiskers, asbestos, metallic fibers and ceramic fibers; flame retardants such as antimony trioxide, magnesium

carbonate and calcium carbonate; electrical property improvers such as clay and mica; anti-tracking agents such as asbestos, silica and graphite; acid resistance improvers such as barium sulfate, silica and calcium metasilicate; heat conductivity improvers such as iron powder, zinc powder, aluminum powder and copper powder; and other miscellaneous fillers such as glass beads, glass spheres, talc, diatomaceous earth, alumina, silicate balloons, hydrated alumina, metal oxide and colorants.

The present invention will hereinafter be illustrated further in detail by way of synthesis examples, examples and comparative examples.

Synthesis Example 1

A reaction vessel equipped with a stirrer, reflux condenser thermometer, water separator and a nitrogen inlet tube was charged with 1410 g of dehydrated N,N-dimethylformamide, 207.6 g (0.6 mole) of 1,4-bis(4-hydroxy-α,α-dimethylbenzyl)benzene, 193.7 g (1.23 mole) of 4-chloronitrobenzene and 248.8 g (1.8 mole) of potassium carbonate, and 50 g of toluene was added. The resulting mixture was heated to 140 to 150 °C and reacted for 5 hours with stirring at the temperature. Water formed by the reaction was successively removed by azeotropic distillation with toluene.

After finishing the reaction, the reaction mixture was filtered to remove inorganic salts. The filtrate was heated to 90 to 95 °C and 210 g water was added dropwise over 2 hours to crystallize 1,4-bis [ 4-(4-nitrophenoxy)-α,α-dimethylbenzyl] benzene. The mixture was gradually cooled and the light yellow crystal was filtered, washed with a mixture of N,N-dimethylformamide and methanol, reslurried with 1ℓ of methanol, filtered and dried to obtain 335 g of light yellow powder. The purity was 99.3% as determined by high performance liquid chromatography. Melting point was 186.5-188.5 °C.

| Elementaly analysis | | | |
|---|---|---|---|
| | C | N | H |
| Calculated (%) | 73.47 | 4.76 | 5.44 |
| Found (%) | 73.28 | 4.96 | 5.56 |

IR (KBr tablet method)
1330, 1500 $cm^{-1}$ (nitro group)
1240 $cm^{-1}$ (ether linkage)

To a sealed reduction vessel equipped with a stirrer and a thermometer, 294 g (0.5 mole) of above obtained 1,4-bis [4-(4-nitrophenoxy)-α,α-dimethylbenzyl] benzene, 1175 g of N,N-dimethylformamide and 17.5 g of 5 % Pd/C catalyst were charged and hydrogen gas was introduced with vigorous stirring. The reaction was carried out at 30 to 40 °C for 4 hours and 67.2 ℓ of hydrogen was absorbed. The reaction was terminated because no more hydrogen was absorbed.

The reaction mixture was filtered to remove the Pd/C catalyst. The filtrate was heated to 80 to 90 °C and 500 g of water was added dropwise over 2.5 hours at the temperature to crystallize 1,4-bis [4-(4-aminophenoxy)-α,α-dimethylbenzyl] benzene.

The mixture was gradually cooled and the precipitated white crystals were filtered, washed with a mixture of N,N-dimethylformamide and methanol, washed with methanol and dried to obtain 252.8 g of 1,4-bis [4-(4-aminophenoxy)-α,α-adimethylbenzyl] benzene. The purity was 99.2 % by high performance liquid chromatography. The overall yield was 88.3 %. Melting point was 189-190.5 °C.

| Elementaly analysis | | | |
|---|---|---|---|
| | C | N | H |
| Calculated (%) | 81.82 | 5.30 | 6.82 |
| Found (%) | 81.90 | 5.21 | 6.75 |

IR (KBr tablet method); 1620, 3320-3430 $cm^{-1}$ (aminogroup 1230 $cm^{-1}$ (ether linkage)

Synthesis Example 2

A reaction vessel equipped with a stirrer, reflux condenser, thermometer, water separator and a nitrogen inlet tube was charged with 600 g of dehydrated N,N-dimethylformamide, 207.6 g (0.6 mole) of 1,3-bis(4-hydroxy-α,α-dimethylbenzyl)benzene, 193.7 g (1.23 mole) of 4-chloronitrobenzene and 248.8 g (1.8 mole) of potassium carbonate, and 50 g of toluene was added. The resulting mixture was heated to 140 to 150 °C and reacted for 5 hours with stirring at the temperature. Water formed by the reaction was successively removed by azeotropic distillation with toluene.

After finishing the reaction, the reaction mixture was filtered to remove inorganic salts. The filtrate was heated to 90 to 95 °C and 210 g of water was added dropwise over 2 hours to crystallize 1,3-bis [4-(4-nitrophenoxy)-α,α-dimethylbenzyl] benzene. The mixture was gradually cooled and the light yellow crystals were filtered, washed with a mixture of N,N-dimethylformamide and methanol, reslurried with 1ℓ of methanol, filtered and dried to obtain 328 g of light yellow powder. The purity was 99.1 % by high performance liquid chromatography.
Melting point was 154.5 - 156 °C.

| Elementary analysis | | | |
|---|---|---|---|
| | C | N | H |
| Calculated (%) | 73.47 | 4.76 | 5.44 |
| Found (%) | 73.34 | 4.79 | 5.20 |

IR (KBr tablet method)
1330, 1490 $cm^{-1}$ (nitro group)
1230 $cm^{-1}$ (ether linkage)

To a reaction vessel equipped with a stirrer, thermometer, reflux condenser and a dropping funnel, 294 g (0.5 mole) of 1,3-bis [4-(4-nitrophenoxy)-α,α-dimethylbenzyl] benzene, 1500 g of methoxyethanol, 29.4 g of activated carbon and 2.9 g of ferric chloride hexahydrate were charged and stirred for 3 hours at 100 to 105 °C. Thereafter 150.2 g of 80 % hydrazine monohydrate was added dropwise over 3 hours while stirring.

After aging for an hour at the same temperature, solid material was removed by hot-filtration. The filtrate was concentrated and recrystallized from isopropyl alcohol to obtain the desired 1,3-bis [4-(4-aminophenoxy)-α,α-dimethylbenzyl] benzene as white crystals.

The white crystals were filtered, washed with isopropyl alcohol and dried to obtain 228.5 g of 1,3-bis [4-(4-aminophenoxy)-α,α-dimethylbenzyl] benzene.
The purity was 99.0 % by high performance liquid chromatography. The overall yield was 81.5 %.
Melting point was 103 - 105.5 °C.

| Elementary analysis | | | |
|---|---|---|---|
| | C | N | H |
| Calculated (%) | 81.82 | 5.30 | 6.82 |
| Found (%) | 81.86 | 5.22 | 6.45 |

IR (KBr tablet method);
1620, 1340-1440 $cm^{-1}$(amino group)
1240 $cm^{-1}$(ether linkage)

Example 1

To a reaction vessel equipped with a stirrer, reflux condenser, water separator and a nitrogen inlet tube, 15.84 g (0.03 mole) of 1,4-bis [4-(4-aminophenoxy)-α,α-dimethylbenzyl] benzene, 6.213 g (0.0285 mole) of pyromellitic dianhydride, 0.444 g ($3\times10^{-3}$ mole) of phthalic anhydride, 0.83 g of γ-picoline and 208 g of m-cresol were charged and heated to 145 °C with stirring in a nitrogen atmosphere. During the time, about 1 *ml* of water was distilled out. The reaction was carried out at 140 to 150 °C for 4 hours. The reaction mixture was cooled to room temperature and poured into about 1000 g of methyl ethyl ketone. The

precipitated polyimide powder was filtered, washed with methyl ethyl ketone and dried at 180 °C for 24 hours under reduced pressure. The polyimide powder thus obtained was 21.2 g (98.5 % yield) and had an inherent viscosity of 0.77 dℓ/g.

The inherent viscosity was measured at 35 °C after heat-dissolving 0.5 g of polyimide powder in 100 *ml* of a solvent mixture of p-chlorophenol/phenol in a ratio of 9/1 by weight. The polyimide had a glass transition temperature of 246 °C, melting point of 340 °C (measured by DSC method), and a 5 % weight loss temperature of 530 °C in air (measured by DTA-TG method).

The IR absorption spectrum diagram of the polyimide powder is illustrated in Figure 1. In the diagram, remarkable absorptions are found at around 1780 $cm^{-1}$ and 1720 $cm^{-1}$ which are characteristic absorption bands of imide group and around 1240 $cm^{-1}$ which is a characteristic absorption band of the ether linkage.

Results of elementary analysis on the polyimide powder thus obtained were as follows.

| | C | N | H |
|---|---|---|---|
| Calculated (%) | 77.83 | 3.92 | 4.80 |
| Found (%) | 77.86 | 3.93 | 4.77 |

The polyimide powder was quite insoluble in halogenated hydrocarbon solvents such as methylene chloride and chloroform.

Melt viscosity of the polyimide powder thus obtained was measured with a KOKA-model flow tester (CFT-500, a product of Shimadzu Seisakusho Co. Ltd.) under load of 100 kg by using an orifice of 0.1 cm in diameter and 1 cm in length. The melt viscosity was 13200 poise at 400 °C and 7600 poise at 420 °C. The strands obtained were red brown and transparent and had a high flexibility.

Comparative Example 1

Commercially available pellets of ULTEM 1000 (Trade Mark of General Electric Co. Ltd.) having the formula (III) were dissolved in methylene chloride. The solubility was 20 % by weight or more.

Example 2

The same procedures as described in Example 1 were carried out using 1,3-bis [4-(4-aminophenoxy)-α,α-dimethylbenzyl] benzene in place of 1,4-bis [4-(4-aminophenoxy)-α,α-dimethylbenzyl] benzene.

The polyimide powder thus obtained was 21.1 g (98 % yield) and had an inherent viscosity of 0.56 dℓ/g.

The polyimide powder had a glass transition temperature of 236 °C, melting point of 292 °C, and a 5 % weight loss temperature of 528 °C in air.

The IR absorption spectrum diagram of the polyimide powder is illustrated in Figure 2. In the diagram, remarkable absorptions are found at around 1780 $cm^{-1}$ and 1720 $cm^{-1}$ which are characteristic absorption bands of imide group and around 1240 $cm^{-1}$ which is a characteristic absorption band of the ether linkage.

Results of elementary analysis on the polyimide powder thus obtained were as follows.

| | C | N | H |
|---|---|---|---|
| Calculated (%) | 77.83 | 3.92 | 4.80 |
| Found (%) | 77.80 | 3.90 | 4.82 |

Example 3

To a reaction vessel equipped with a stirrer, reflux condenser and a nitrogen inlet tube, 5.28 g (0.01 mole) of 1,4-bis [4-(4-aminophenoxy)-α,α-dimethylbenzyl] benzene and 42.27 g of N,N-dimethylacetamide were charged. In a nitrogen atmosphere, 2.16 g(0.099 mole) of pyromellitic dianhydride was added by portions at room temperature with caution to prevent temperature rise of the solution. The mixture was stirred for 20 hours at the room temperature. The polyamic acid thus obtained had an inherent viscosity of 1.86 dℓ/g.

The inherent viscosity was measured at 35 °C with a N,N-dimethylacetamide solution in a concentration of 0.5 g/100 *ml* solvent.

A portion of the polyamic acid solution was cast on a glass plate and heated for an hour at 100 °C, 200 °C and 300 °C, respectively. The polyimide film obtained had a thickness of about 25 μm.

The polyimide film had a tensile strength of 13.8 kg/mm$^2$ and an elongation of 8.0 % in accordance with ASTM D-882 and a glass transition temperature of 257 °C which is measured by a TMA penetration method. Further, the film had a water absorption of 0.62 % after immersing into water at 23.5 °C for 24 hours in accordance with ASTM D570-63.

Comparative Example 2

As a result of measuring water absorption by carrying out the same procedures as described in Example 3, commercially available Kapton 100 H (Trad Mark of E.I. Du Pont De Nemours & Co. Inc.) had a water absorption of 2.9 %.

Example 4

The same procedures as described in Example 3 were carried out except that
1,4-bis [4-(4-aminophenoxy)-α,α-dimethylbenzyl] benzene was replaced by
1,3-bis [4-(4-aminophenoxy)-α,α-dimethylbenzyl] benzene.

The polyamic acid thus obtained had an inherent viscosity of 1.75 dℓ/g.

A portion of the polyamic acid solution was cast on a glass plate and heated for an hour at 100 °C, 200 °C and 300 °C, respectively. The polyimide film thus obtained had a thickness of about 25 μm

The polyimide film also had a tensile strength of 12.0 kg/mm$^2$, elongation of 6.9 %, glass transition temperature of 245 °C and water absorption of 0.68 %.

Examples 5 - 12

The same procedures as described in Examples 3 and 4 were carried out by changing the kind of tetracarboxlic acid dianhydride to obtain polyimide films.

Properties of the polyimide films thus obtained are summarized in Table 1 together with those of Examples 3 and 4.

Table 1

| Example No. | Diamine compound g(mole) | Tetracarboxylic acid dianhydride g(mole) | Polyamic acid inherent viscosity (dℓ/g) |
|---|---|---|---|
| 3 | A (Note) 5.28 (0.01) | pyromellitic dianhydride 2.16 (0.0099) | 1.86 |
| 4 | B (Note) 5.28 (0.01) | pyromellitic dianhydride 2.16 (0.0099) | 1.75 |
| 5 | A (Note) 5.28 (0.01) | 3,3',4,4'-biphenyltetracarboxylic dianhydride 2.91 (0.0099) | 1.55 |
| 6 | A 5.28 (0.01) | 3,3',4,4'-benzophenonetetracarboxylic dianhydride 3.19 (0.0099) | 1.20 |
| 7 | A 5.28 (0.01) | (3,4-dicarboxyphenyl) ether dianhydride 3.07 (0.0099) | 1.45 |
| 8 | A 5.28 (0.01) | 4,4'-(p-phenylenedioxy)diphthalic dianhydride 3.91 (0.0099) | 1.60 |
| 9 | B 5.28 (0.01) | 3,3',4,4'-biphenyltetracarboxylic dianhydride 2.91 (0.0099) | 1.50 |
| 10 | B 5.28 (0.01) | 3,3',4,4'-benzophenone tetracarboxylic dianhydride 3.19 (0.0099) | 1.15 |
| 11 | B 5.28 (0.01) | (3,4-dicarboxyphenyl)ether dianhydride 3.07 (0.0099) | 1.40 |
| 12 | B 5.28 (0.01) | 4,4'-(p-phenylenedioxy)diphthalic dianhydride 3.98 (0.0099) | 1.50 |

(Note) A: 1,4-bis [4-(4-aminophenoxy)-α,α-dimethylbenzyl] benzene
B: 1,3-bis [4-(4-aminophenoxy)-α,α-dimethylbenzyl] benzene

Table 1 (continued)

| Example No. | Polyimide film | | | |
|---|---|---|---|---|
| | Glass transition temperature (℃) | Tensile strength (kg/mm²) | Elongation (%) | water absorption (%) |
| 3 | 257 | 13.8 | 11.0 | 0.62 |
| 4 | 245 | 12.0 | 6.0 | 0.68 |
| 5 | 239 | 12.3 | 9.5 | 0.52 |
| 6 | 227 | 14.1 | 7.2 | 0.60 |
| 7 | 204 | 13.1 | 8.7 | 0.50 |
| 8 | 201 | 14.5 | 10.6 | 0.44 |
| 9 | 228 | 10.7 | 10.0 | 0.57 |
| 10 | 216 | 12.7 | 4.9 | 0.61 |
| 11 | 199 | 11.4 | 7.7 | 0.56 |
| 12 | 195 | 12.7 | 9.2 | 0.49 |

## Claims

**1.** A polyimide having recurring structural units represented by the formula (I):

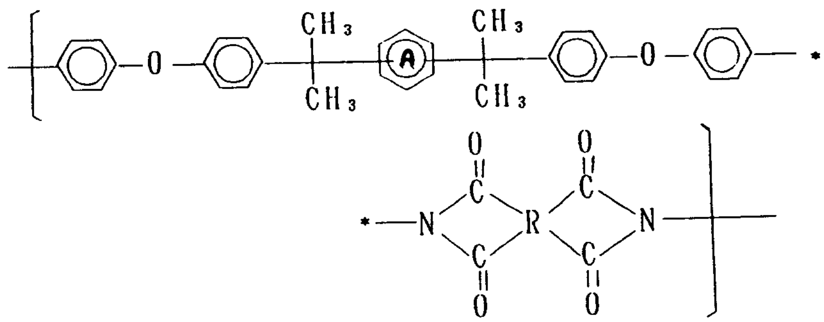

(I)

wherein R is a tetravalent radical selected from the group consisting of an aliphatic radical having at least two carbon atoms, alicyclic radical, monocyclic aromatic radical, fused polycyclic aromatic radical and polycyclic aromatic radical bonded through a direct bond or a bridge member, and ring A is 1,3 or 1,4-substituted.

**2.** A polyimide having recurring structural units of the formula (VI):

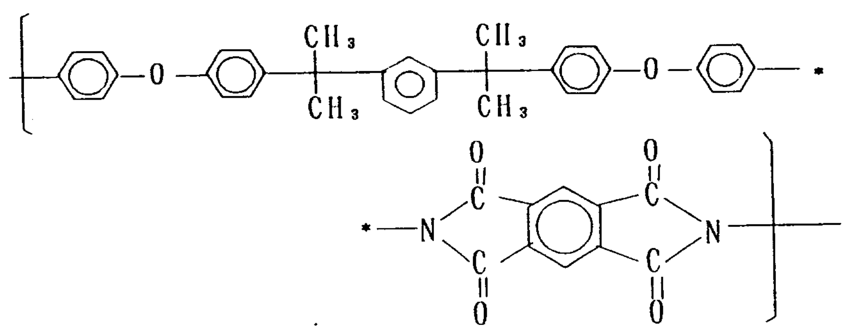

(VI)

**3.** A polyimide having the recurring structural units of the formula (VII):

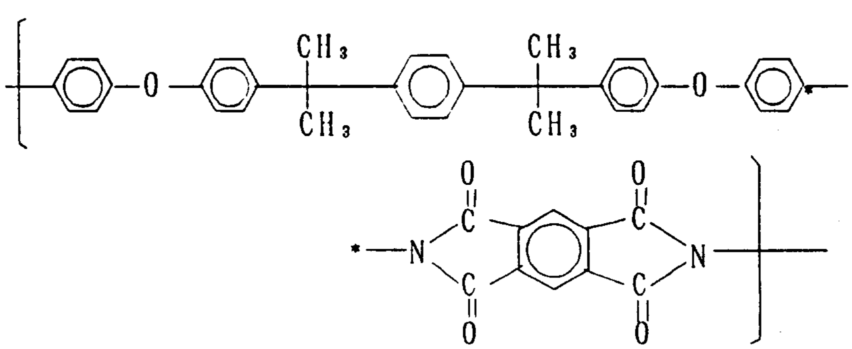

(VII)

**Patentansprüche**

**1.** Polyimid mit wiederkehrenden Struktureinheiten dargestellt durch die Formel (I):

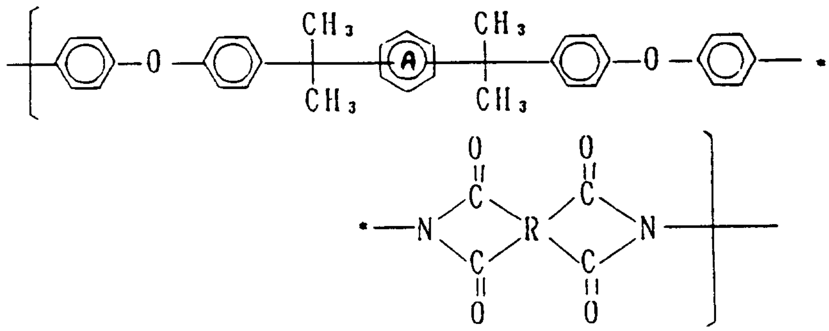

( I )

worin R ein vierwertiger Rest ist ausgewählt aus der Gruppe bestehend aus einem aliphatischen Rest mit zumindest zwei C-Atomen, einem alizyklischen Rest, einem monozyklischen aromatischen Rest, einem kondensierten polyzyklischen aromatischen Rest und einem polyzyklischen aromatischen Rest, der durch eine direkte Bindung oder durch ein Brückenelement gebunden ist, und worin der Ring A 1,3- oder 1,4-substituiert ist.

**2.** Polyimid mit wiederkehrenden Struktureinheiten der Formel (VI): (VI):

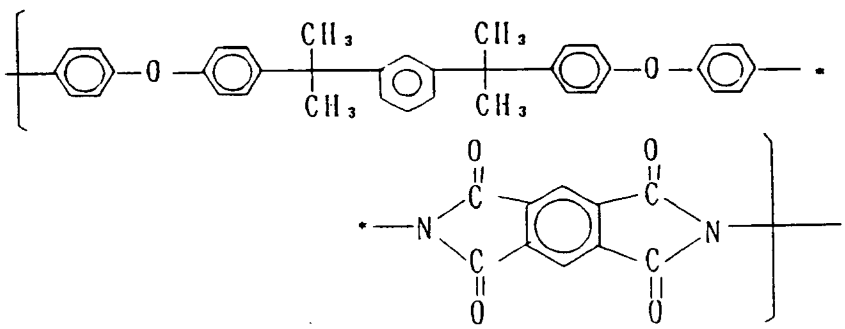

(VI)

**3.** Polyimid mit wiederkehrenden Struktureinheiten der Formel (VII):

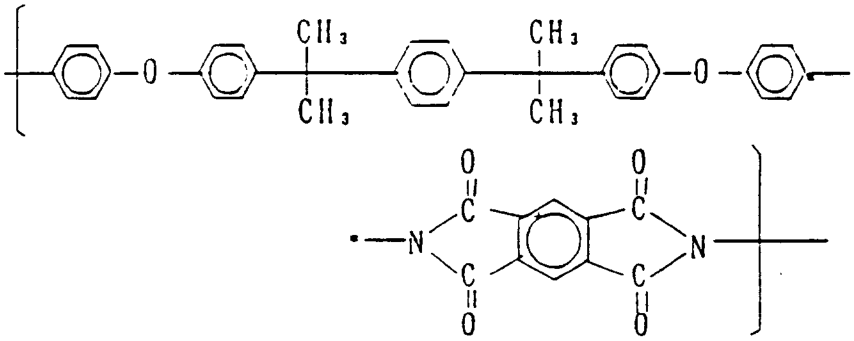

(VII)

## Revendications

**1.** Polyimide ayant des unités récurrentes de structure représentées par la formule (I) :

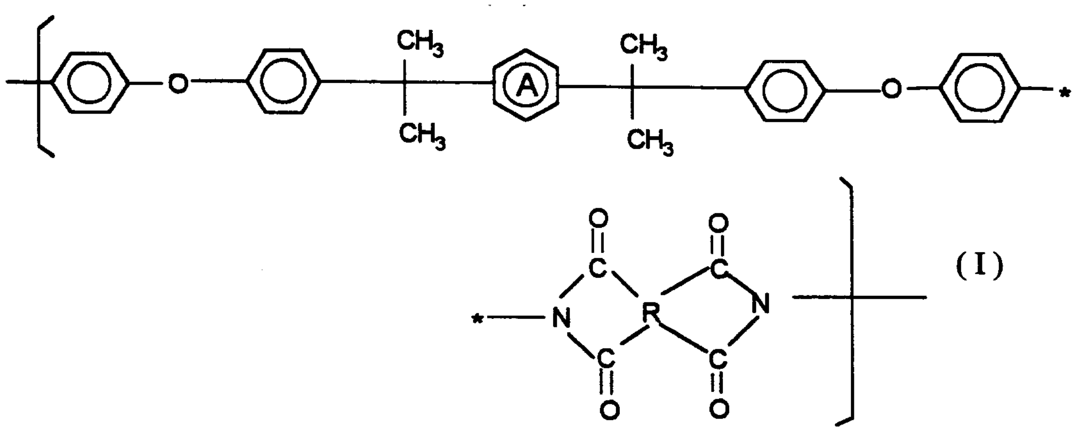

(I)

où R est un radical tétravalent choisi dans le groupe consistant en un radical aliphatique ayant au moins deux atomes de carbone, un radical alicyclique, un radical aromatique monocylique, un radical aromatique polycyclique fondu et un radical aromatique polycyclique lié par une liaison directe ou un organe formant pont et le noyau A est 1,3 ou 1,4-substitué.

**2.** Polyimide ayant des unités récurrentes de structure de la formule (VI) :

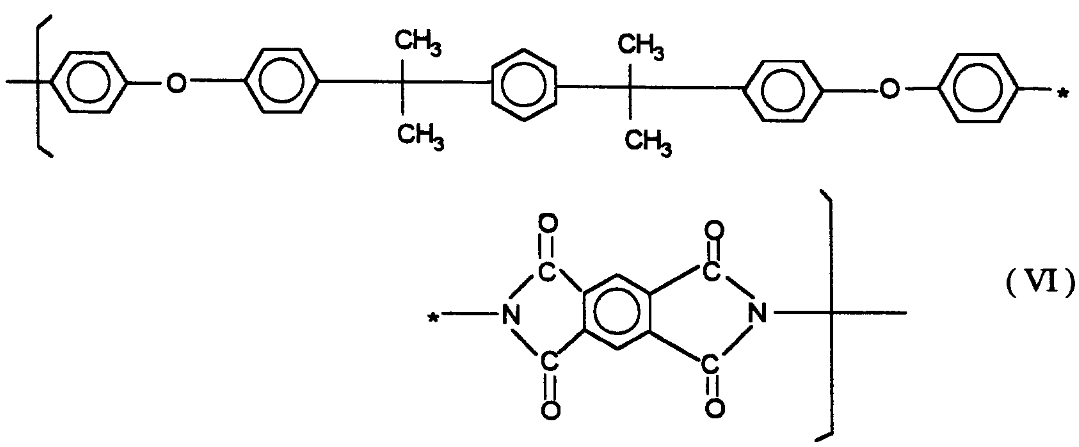

(VI)

**3.** Polyimide ayant les unités récurrentes de structure de la formule (VII) :

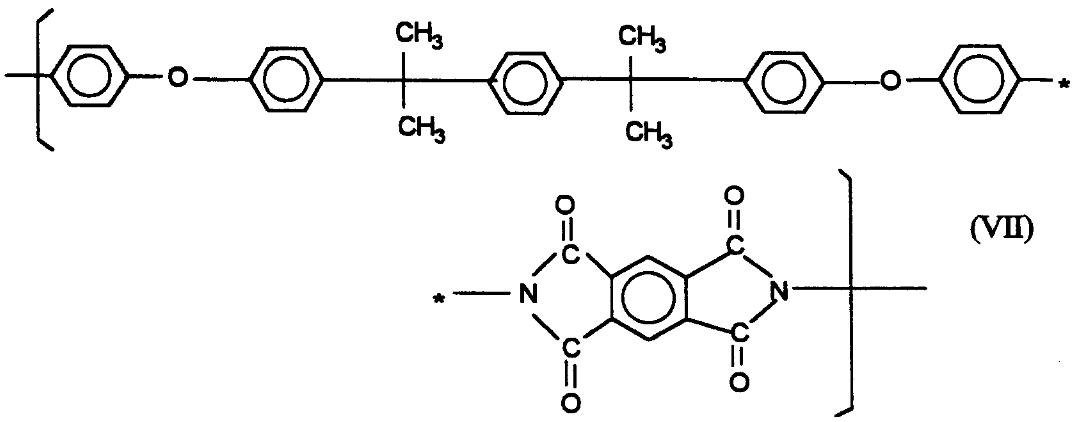

(VII)

FIG. 1

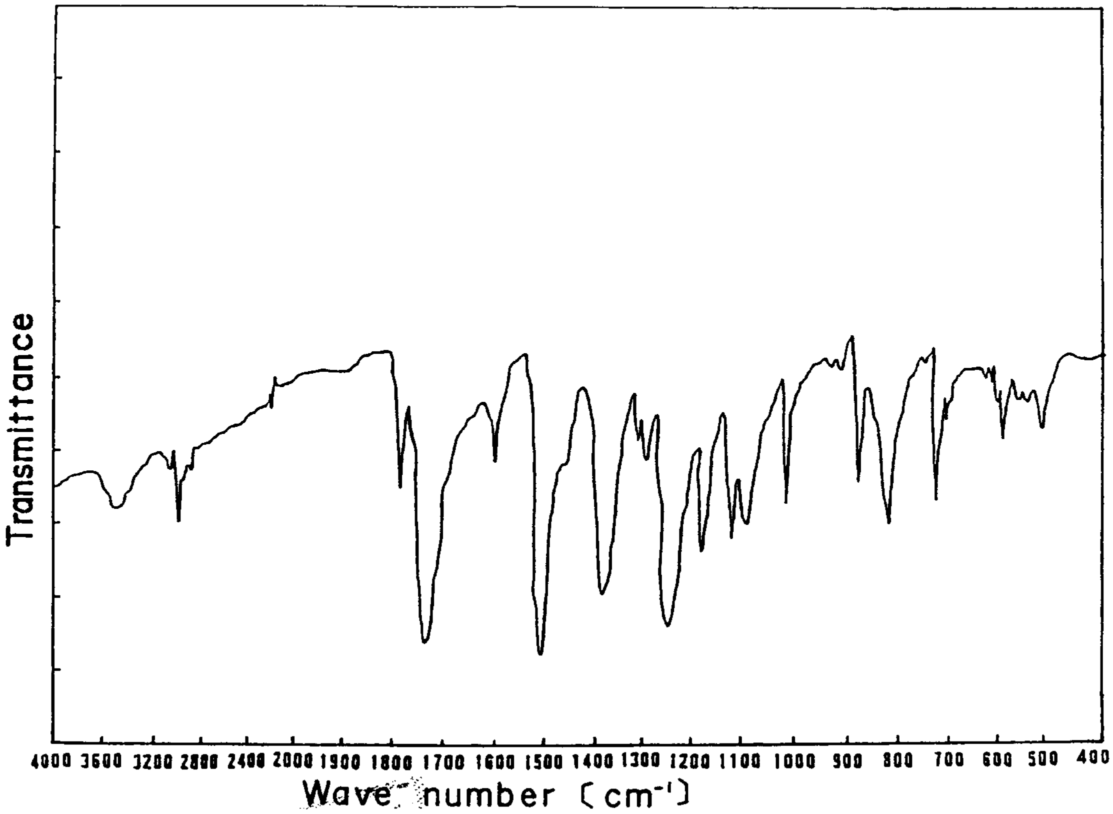
Transmittance
4000 3600 3200 2800 2400 2000 1900 1800 1700 1600 1500 1400 1300 1200 1100 1000 900 800 700 600 500 400
Wave number [cm$^{-1}$]

FIG. 2

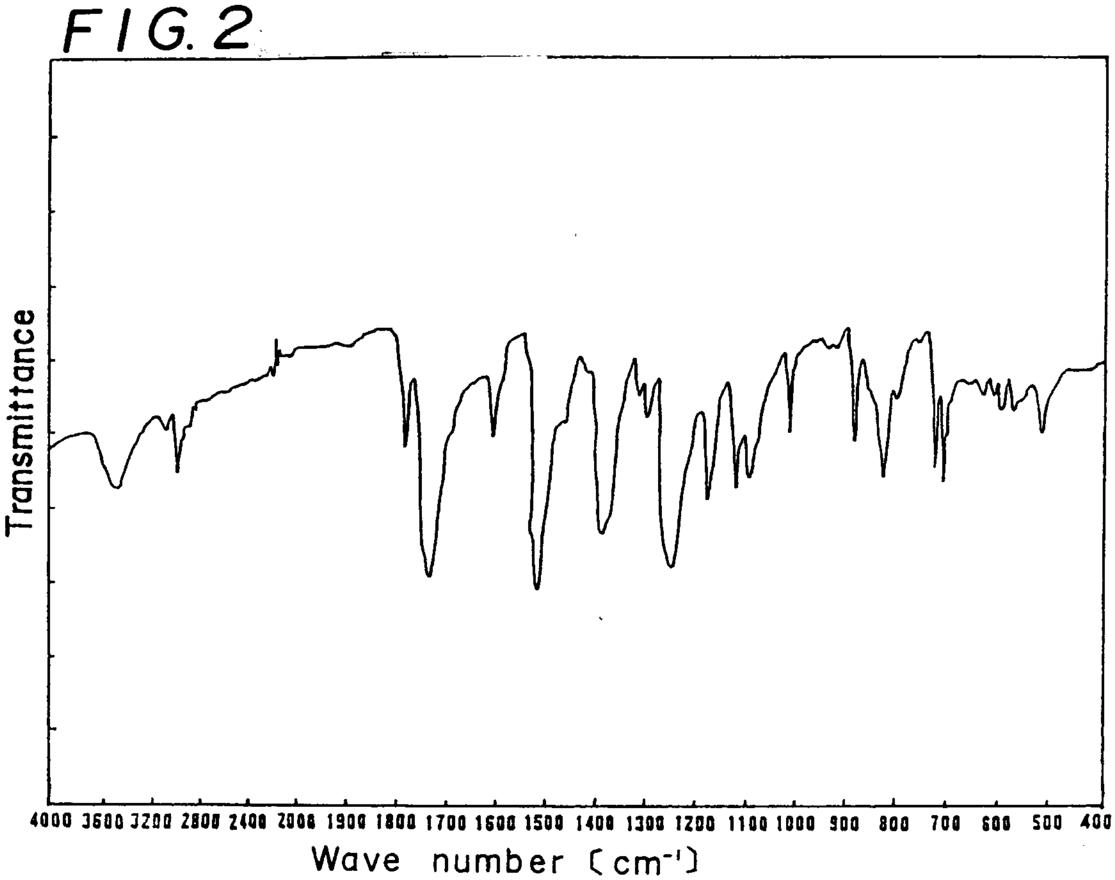
Transmittance
4000 3600 3200 2800 2400 2000 1900 1800 1700 1600 1500 1400 1300 1200 1100 1000 900 800 700 600 500 400
Wave number [cm$^{-1}$]